# EUROPEAN PATENT SPECIFICATION

(11) **EP 4 122 187 B1**
(45) Date of publication and mention of the grant of the patent: **29.07.2026**
(21) Application number: 21711264.8
(22) Date of filing: 15.03.2021
(51) Int. Cl.: H04M 1/22, A24F 40/40

(54) **AEROSOL GENERATION DEVICE WITH NON-VISIBLE ILLUMINATION UNIT**
AEROSOLERZEUGUNGSVORRICHTUNG MIT NICHT SICHTBARER BELEUCHTUNGSEINHEIT
DISPOSITIF DE GÉNÉRATION D'AÉROSOL AVEC UNE UNITÉ D'ÉCLAIRAGE NON VISIBLE

(30) Priority: 18.03.2020 EP 20164043
(43) Date of publication of application: 25.01.2023
(73) Proprietor: JT International SA, 1202 Geneva (CH)
(72) Inventor: BOUCHUIGUIR, Layth Sliman, 1293 Bellevue (CH); PLEVNIK, Marko, London NW3 2JR (GB); INOUE, Norihiko, London E1 3EX (GB)
(74) Representative: Bardehle Pagenberg Partnerschaft mbB Patentanwälte Rechtsanwälte
(86) International application number: PCT/EP2021/056530
(87) International publication number: WO 2021/185760

(56) References cited:
- EP-A2- 1 971 112
- WO-A1-2019/110920
- US-A1- 2018 360 119
- US-B1- 8 499 766

## Description

### TECHNICAL FIELD

The present invention relates to an aerosol generation device. In particular, the invention relates to an aerosol generation device with a partially opaque portion for rendering an illumination unit non-visible when the illumination unit is not emitting light.

### TECHNICAL BACKGROUND

Aerosol generation devices commonly comprise light-emitting indicators to indicate technical information or an operational state of the device or the consumable.

Typically, the light-emitting indicators are arranged within the housing of the aerosol generation device, and the housing is provided with light-guide portions or holes to allow the light-emitting indicators to be visible to a user. However, since the lighttransmitting holes or light-guides are visible to a user even when the light-emitting indicators are not emitting any light, discerning between a state in which the light-emitting indicators are emitting light, and state in which the light-emitting indicators are not emitting light, can be become challenging under disadvantageous lighting situations. Additionally, such configurations of the housing are not aesthetically pleasing as they break up the visual appearance of the outer surface of the aerosol generation device.

Furthermore, where an illumination unit for of the aerosol generation device comprises a plurality of light sources forming a contiguous illumination region, visual feedback that indicates a state of the aerosol generation device or a consumable used with the aerosol generation device is typically provided by a number of the light sources being illuminated ("on"), and the remaining light sources not being illuminated ("off"). However, a user may not be able to easily discern those light sources which are "off". This is particularly true where the light sources of the illumination unit which do not emit light are difficult to detect by the eye of the user. The user may therefore have difficulties in understanding where the contiguous illumination region starts and where it ends, which may lead to a difficulty in understanding the value of the state indicated by the illuminated light sources.

US 8 499 766 B1 discloses an electronic cigarette with an illumination function, and that generates an aerosol of a fluid when air is drawn through it, includes a housing with a translucent tip, a mouthpiece, and a battery. US 2018/360119 A1 discloses a portable aerosol device including, a mouthpiece, a cartridge, and a shell configured for inserting the cartridge with a tank into the shell, a viewing window and an LED for illuminating the tank. EP 1 971 112 A2 discloses a mobile communication that includes a housing, a light emitting unit configured to emit at least a first color when the mobile communication device is operated in a first mode and to emit a second color when the mobile communication device is operated in a second mode, and a filtering unit having at least a first pattern associated with the first mode and a second pattern associated with the second mode. The filtering unit is configured to display the first pattern with the first color in the housing when the mobile communication device is operated in the first mode and to display the second pattern with the second color in the housing when the mobile communication device is operated in the second mode.

Therefore, there is a need for an aerosol generation device with housing which is capable of a more reliable indication of information to a user of the device and/or which allows for an aesthetically pleasing design.

### SUMMARY OF THE INVENTION

Some or all of the above objectives are achieved by the invention as defined by the features of independent claim 1. Preferred embodiments of the invention are defined by the features of the dependent claims.

A first aspect of the invention, as defined in claim 1, is an aerosol generation device having a housing, and an illumination unit capable of emitting light and covered by an exterior wall of the housing, the exterior wall comprising or substantially consisting of a light-transmissive portion arranged such that light emitted by the illumination unit is transmitted through the light-transmissive portion, wherein the light-transmissive portion allows the illumination unit to be visible through the light-transmissive portion from the exterior of the device when the illumination unit emits light. The device is characterised in that the light-transmissive portion comprises a laminar structure including a partially or fully transparent layer and a partially light-reflective layer, and the light-transmissive portion prevents the illumination unit from being visible through the light-transmissive portion from the exterior of the device when the illumination unit does not emit light.

The light-transmissive portion allows the illumination unit to be visible when the illumination unit is emitting light. Thus, it may allow the illumination unit to provide visual feedback indicating information regarding the aerosol generation device to a user of the device. On the other hand, the light-transmissive portion prevents the illuminations unit from being visible when it is not emitting light, thus preventing that a user is lead to believe that the illumination unit is signaling certain information about the state of the device or the consumable, when in fact it is not.

Furthermore, the non-visible illumination unit prevents any visual breakup of the lines and surfaces of the exterior surface of the device housing, which allows for an aesthetically pleasing design. It should be noted that term "not visible" refers to a nonvisibility to the human eye that is achieved under common ambient lighting conditions.

The laminar structure may be adapted to suit different requirements and needs for the aerosol generation device and the respective production processes.

According to a third aspect, in the preceding aspect, the partially or fully transparent layer is arranged closer the illumination unit than the partially light-reflective layer. The light-reflective layer further improves the optical property of the light-transmissive portion by reflecting substantial parts of the light incident on the light-reflective layer from an exterior of the housing to improve concealment of the illumination unit when the illumination unit is not emitting light, and simultaneously allows light to transmitted through the light-reflective layer to an exterior of the housing to allow the illumination unit to visible through the light-transmissive layer when the illumination unit is emitting light.

According to a fourth aspect, in the preceding aspect, the partially light-reflective layer comprises a coating created by a physical vapor deposition (PVD), chemical vapor deposition (CVD) and/or non-conducting vacuum metallization (NCVM) process. These processes allow the accurate and precise deposition of layers onto a surface with well-defined properties for achieving desired optical properties of the light-reflective layer.

According to a fifth aspect, in any one of the second to fourth aspects, the partially light-reflective layer comprises an aluminum, copper, or bronze material. These are commonly available and cost-efficient materials that provide well-known light-reflective properties.

According to a sixth aspect, in any one of the preceding aspects, the laminar structure comprises a light-diffusive layer. The light-diffusive layer further aids in rendering the illumination unit non-visible when the illumination unit is not emitting light, while simultaneously allowing light to be transmitted through the light-diffusive layer.

According to a seventh aspect, in the preceding aspect, the light-diffusive layer forms the exterior surface of the light-transmissive portion. A light-diffusive layer as the exterior layer serves as a protective layer since damages to a light-diffusive layer, such as scratches, bumps, indentations and small holes are less visible on the light-diffusive layer due to the light-diffusive property than on a shiny, glossy or mirrored exterior layer.

According to an eighth aspect, in any one of the second to seventh aspects, one or more layers of the laminar structure are colored or tinted. This allows the light-transmissive portion to appear in various colors and tints for different visual appearances.

According to a ninth aspect, in any one of the preceding aspects, the housing comprises a main body on which the illumination unit is arranged, and a panel member that is movably and/or detachably attached to the main body and that comprises or substantially consists of the exterior wall of the housing. A movable and/or detachable panel that comprises the light-transmissive layer allows easy and convenient access to the illumination unit and other parts of the aerosol generation device in case maintenance or repairs are required.

According to a tenth aspect, in any one of the preceding aspects, the shape and/or length and/or width and/or radius of the light-transmissive portion corresponds to the shape and/or length and/or width and/or radius, respectively, of the illumination unit. This improves the homogenous illumination of the light-transmissive portion by light emitted from the illumination unit.

According to an eleventh aspect, in any one of the preceding aspects, the length and/or width and/or radius of the light-transmissive portion is so small that the light-transmissive portion is not visibly discernible from the exterior of the device when the illumination unit does not emit light. This further serves for rendering the illumination unit non-visible to the human eye when the illumination unit is not emitting light.

According to a twelfth aspect, in any one of the preceding aspects, the illumination unit is positioned such that at least parts of the light emitted by the illumination unit passes through the light-transmissive portion in a direction substantially perpendicular to the exterior surface of the exterior wall of the housing. This aspect makes clear that the position of the light-transmissive portion substantially corresponds to the position of the illumination unit and ensures transmission of light emitted from the illumination unit through the light-transmissive portion to an exterior side of the light-transmissive portion.

According to a thirteenth aspect, in any one of the preceding aspects, the light-transmissive portion and at least parts of the housing adjacent to the light-transmissive portion and/or substantially the entire exterior wall of the housing are provided with substantially the same exterior surface finish. This reduces the visibility of transitions between the light-transmissive portion and adjacent parts of the housing such that the light-transmissive portion and the device housing are not visually discernible, to further conceal the illumination unit when no light is emitted.

According to a fourteenth aspect, in the preceding aspect, the surface finish is a glossy, mirrored, or matte finish. This allows the light-transmissive portion to appear with a desired visual effect, and may further improve concealment of the illumination unit when not emitting light. Furthermore, a glossy or mirrored surface finish may improve tactile grip of the exterior surface of the light-transmissive portion, while a matte finish may provide a finish that can mask or hide surface imperfections due to, for example, the aerosol generation device being subjected to wear and tear.

According to a fifteenth aspect, in the preceding aspect, the surface finish is provided by one of the light-reflective layer, the light-diffusive layer, and a combination thereof. This may eliminate the need for an additional or separate step for providing a surface finish.

According to a sixteenth aspect, in any one of the preceding aspects, the illumination unit comprises one or more LED light sources or LED light strips. LED light sources offer high energy efficiency, longevity, miniaturization capabilities and low heat generation, making them ideal for use in small and portable devices such as an aerosol generation device.

According to a seventeenth aspect, in any one of the preceding aspects, the illumination unit comprises a plurality of light sources arranged in a straight or curved line.

An eighteenth aspect of the invention is an illumination unit for an aerosol generation device, comprising a plurality of light sources, wherein each of the light sources is configured to operate in a first power operation mode illuminating the light source at a first brightness level, and a second power mode for illuminating the light source at a second brightness level different from the first brightness level, wherein one or more light sources of the plurality of light sources form a contiguous illumination region when the one or more of the plurality of light source are emitting light, and wherein the illumination region is configured to provide to a user visual feedback that indicates a state of the aerosol generation device or a consumable used with the aerosol generation device. Like in the prior art, a state may be indicated by operating a number of the light sources in the first power operation mode ("on"). However, the difference in brightness between the first brightness level and the second brightness level allows the illumination unit to operate (illuminate) even those light sources which are "off", e.g. with less power, rather than operating them not at all. This has the advantage that a user can more easily discern even those light sources which are "off". This is particularly true if the illumination unit is used in an aerosol generation device according to any one of the first to seventeenth aspects, where the illumination unit is not visible from the exterior of the device when the illumination unit does not emit light, or in general in a device where the light sources of the illumination unit which do not emit light are difficult to detect by the eye of the user.

According to a nineteenth aspect, in the preceding aspect, the illumination region comprises a region illuminated at the first brightness level and/or a region illuminated at the second brightness level. This enables the illumination unit to indicate states based on the region at the first brightness level and the region at the second brightness level.

According to a twentieth aspect, in the preceding aspect, the full extent of the illumination region is either the extent of a region illuminated at the first brightness level, if the illuminated region contains only the region illuminated at the first brightness level, or the combined extent of a region illuminated at the first brightness level and a region illuminated at the second brightness level, if the illumination region contains only the region illuminated at the first brightness level and the region illuminated at the second brightness level, or the extent of a region at the second brightness level, if the illumination region contains only the region illuminated at the second brightness level.

According to a twenty-first aspect, in the nineteenth or twentieth aspects, the visual feedback is based on a relation between the extent of the region illuminated at the second brightness level and the full extent of the illumination region. This enables the illumination unit to indicate a state based on the full extent of the illumination region as a reference for the indicated state.

According to a twenty-second aspect, in the eighteenth to twenty-first aspects, the full extent of the illumination region is indicative of a maximum range of values of a state indicated by the visual feedback.

According to a twenty-third aspect, in the preceding aspect, the extent of the region illuminated at the second brightness level is indicative of the a sub-range within the maximum range of values for the indicated information, and the extent of the sub-range in relation to the extent of the maximum range of values corresponds to the extent of the region illuminated at the second brightness level in relation to the full extent of the illumination region. This enables the illumination unit to indicate more complex states, in particular states within a reference range or in relation to a particular reference point of technical relevance to the aerosol generation device or the consumable in use with the aerosol generation device.

According to a twenty-fourth aspect, in any one of the eighteenth to twenty-third aspects, each of the plurality of light sources is an LED which is capable of emitting light in a plurality of colors.

According to a twenty-fifth aspect, in the preceding aspect, the illumination region is illuminated in a color.

According to a twenty-sixth aspect, in any one of the twenty-fourth or twenty-fifth aspects, different colors of the illumination region are indicative of different types of information. This enables to illumination unit to indicate several types of states.

According to a twenty-seventh aspect, in any one of the eighteenth to twenty-sixth aspects, the illumination unit is configured to form one or more patterns on the illumination region, wherein each of the one or more patterns is indicative of different states of the aerosol generation device or a consumable used with the aerosol generation device. This enables the illumination unit to simultaneously indicate one or more types of states.

According to a twenty-eighth aspect, in the preceding aspect, at least one of the one or more patterns includes a moving pattern or a dynamically changing pattern.

According to a twenty-ninth aspect, in the preceding aspect, the moving direction of the moving pattern indicates a change in the state indicated by the one of the one or more patterns. The twenty-eighth and twenty-ninth aspects of the invention enable to illumination unit to indicate changes in an indicated state.

According to a thirtieth aspect, in any one of the eighteenth to twenty-ninth aspects, the states of the aerosol generation device or a consumable used with the aerosol generation device comprise at least one of: elapsed and/or remaining start-up time period of the device, vaping progress on the device, time of use of the device since start-up, consumed and/or remaining amount of aerosol generation substrate in the consumable, an operational temperature of the device, and depletion level of a battery of the device. Indicating these states to a user provides the user with information based on which the user can correctly operate, maintain and/or care for the aerosol generation device or the consumable in use with the aerosol generation device.

According to a thirty-first aspect, in the preceding aspect, the start-up time period is a time period required for heating-up a heating unit comprised by the aerosol generation device before the user can start consuming the consumable. This enables the user to operate the aerosol generation device and the consumable in use with the aerosol generation device in a predetermined manner.

According to a thirty-second aspect, in any one of the eighteenth to thirty-first aspects, the plurality of light sources is arranged in a straight or curved line, and/or the illumination region comprises a curved or bent shape.

According to a thirty-third aspect, in any one of the eighteenth to thirty-second aspects, the second brightness level is higher than the first brightness level.

According to a thirty-fourth aspect, in any one of the eighteenth to thirty-third aspects, the first brightness level is at least 2%, preferably at least 3%, more preferably at least 5% of the maximum brightness of each of the light sources, and at most 30%, preferably at most 20%, more preferably at most 15% of the maximum brightness of each of the light sources. These brightness levels offer a compromise between a visibility and visual contrast of regions at the first brightness and energy consumption of the illumination unit.

According to a thirty-fifth aspect, in any one of the eighteenth to thirty-fourth aspects, the second brightness level is at least 70%, preferably at least 80%, more preferably at least 90% of the maximum brightness of each of the light sources. These brightness levels provide an optimal contrast between regions of the illumination region illuminated at the first brightness level, and regions of the illumination region illuminated at the second brightness level, and further improve visibility of the illumination region under ambient lighting conditions.

According to a thirty-sixth aspect, in the first aspect, the illumination unit is an illumination unit according to any one of the eighteenth to thirty-fifth aspects of the invention.

According to a thirty-seventh aspect, in any one of the first to eighteenth aspects, the illumination unit comprises or substantially consists of a light source that is configured to generate light. It should be noted that a light source is a component or element that generates light.

According to a thirty-eighth aspect, in the preceding aspect, the light source comprises or substantially consists of a luminescent light source. Luminescent light sources typically are advantageous over commonly employed incandescent light sources due to their higher efficiency and compact size.

According to a thirty-ninth aspect, in any one of the first to seventeenth or thirty-seventh to thirty-eighth aspects, the illumination unit is arranged relative to the light-transmissive portion such that the illumination unit emits light directly through the light-transmissive portion. It should be noted that directly means that light emitted from the illumination unit reaches the light-transmissive portion substantially without relying on any scattering or reflecting components such as a light guide or a mirror component. This reduces the overall size of the aerosol generation device as well as the manufacturing costs due to a reduced number of required parts and components.

According to a fortieth aspect, according to the preceding aspect, the illumination unit is configured to emit light through all layers of the light-transmissive portion.

### BRIEF DESCRIPTION OF THE DRAWINGS

Fig. 1 shows a schematic illustration of an aerosol generation device according to embodiments of the invention;
Figs. 2A, 2B and 2C show schematic illustrations of a front view of an aerosol generation device with a light-transmissive portion and an illumination unit, according to embodiments of the invention;
Figs. 3A, 3B and 3C show schematic illustrations of a laminar structure of a light-transmissive portion, respectively, according to embodiments of the invention;
Figs. 4A, 4B, 4C and 4D show schematic illustration of an illumination, respectively, according to embodiments of the invention;
Figs 5A, 5B, 5C, and 5D show schematic illustrations of a front view of an aerosol generation device with an illumination unit, respectively, according to embodiments of the invention.

### DETAILED DESCRIPTION OF PREFERRED EMBODIMENTS

Preferred embodiments of the present invention are described hereinafter and in conjunction with the accompanying drawings.

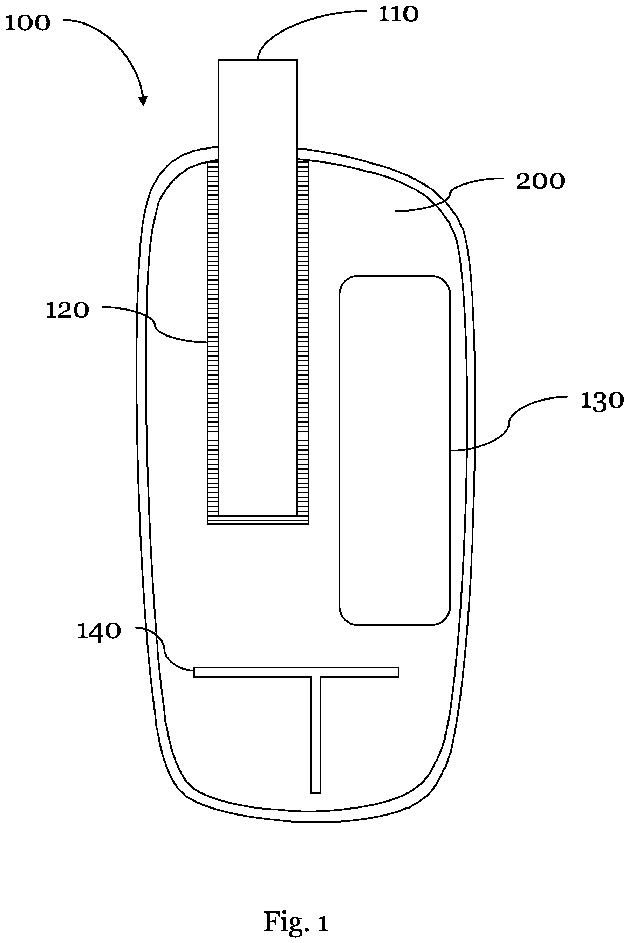

An aerosol generation device 100 as depicted in Fig. 1 commonly comprises a housing with an opening 210 through which an aerosol generation substrate 110 such as a liquid or tobacco stick may at least partially be inserted into an aerosol generation chamber 120 of the device. The device 100 further comprises a power source 130 that may be a rechargeable and/or exchangeable power source such as a battery, and circuitry 140 for controlling operation of the aerosol generation device 100.

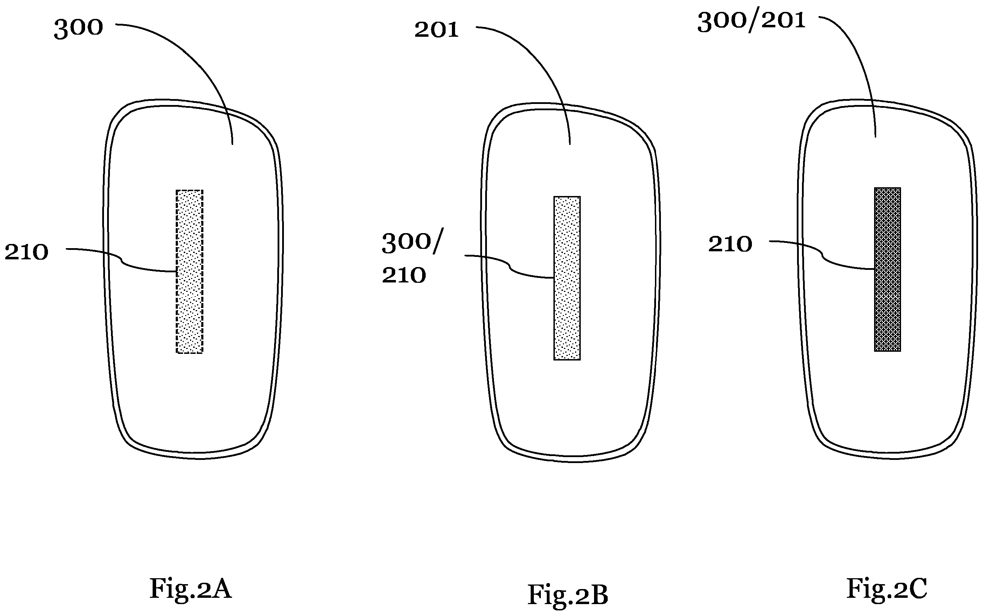

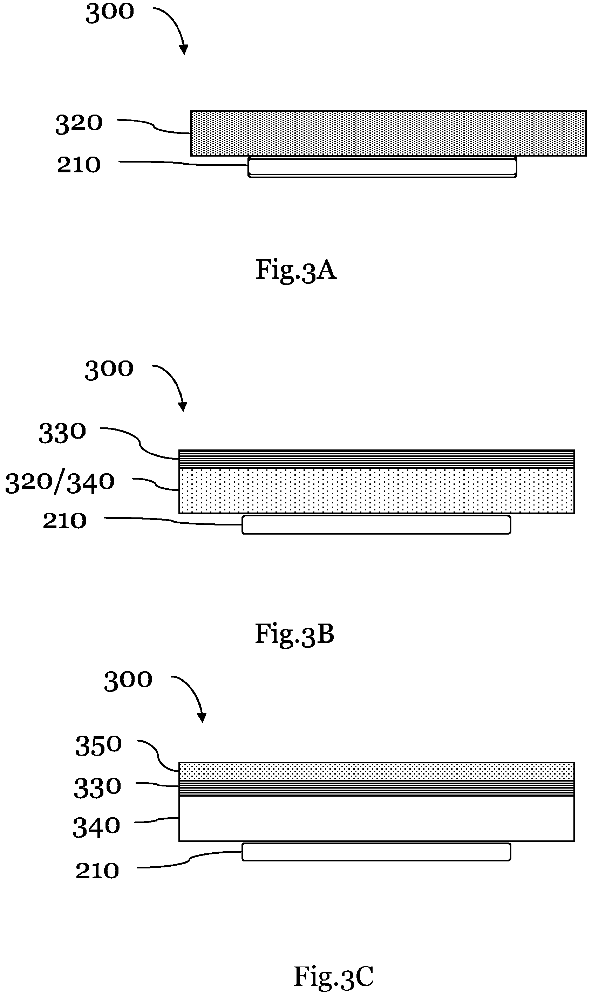

Fig. **2A** shows an aerosol generation device 100 with an exterior wall 200 of the device housing. The exterior wall 200 substantially consists of a light-transmissive portion 300 that covers an illumination unit 210 that is not emitting light. When the illumination unit 210 is not emitting light, the illumination unit is not visible through the light-transmissive portion 300 to the exterior of the aerosol generation device by the human eye. The dotted rectangle in Fig. 2A merely shows a position and extent of the illumination unit 210. The light-transmissive portion may comprise a laminar structure as described below in the context of Figs. 3A, 3B and 3C. The light-transmissive-portion may be provided with a glossy, mirrored, or matte exterior surface finish, and the housing of the aerosol generation device may be provided with the same surface finish as the light-transmissive portion, such that an appearance of the exterior surface of the housing cannot be substantially distinguished from an appearance of the exterior surface of the light-transmissive portion.

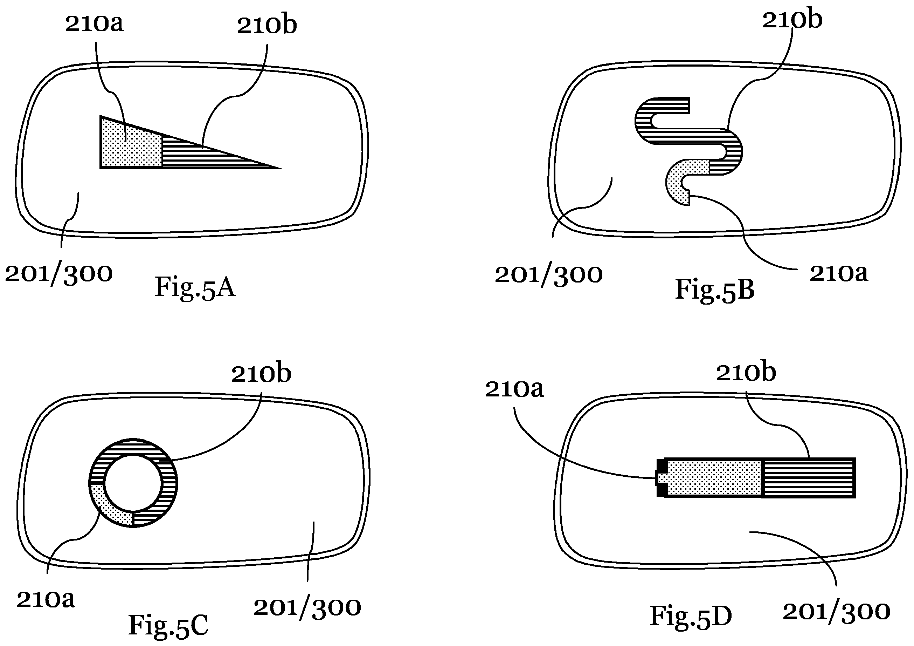

Fig. 2B shows an aerosol generation device 100 with an exterior wall 200 of the device housing, wherein the exterior wall 200 comprises a light-transmissive portion that is only partially the size of the of the exterior wall 200. While the light-transmissive portion is depicted to have a rectangular shape, the shape and/or size of the light-transmissive portion may be of any appropriate shape, such as for example, but not limited to, the shapes and sizes of the light-transmissive portion as described in the context of Figs. 5A to 5D. While a size and position of the illumination unit or illumination region that is covered by the exterior wall 200 and the light-transmissive portion is depicted to substantially match a size and position of the light-transmissive portion in the front view of the aerosol generation device, the size and position of the illumination unit or illumination region may be of any appropriate size and at any appropriate position. The former configuration however is preferred for an optimal illumination performance of the illumination unit through the light-transmissive portion. It should be noted that the illumination unit is covered by and hence not visible through the exterior wall 200 and the light-transmissive portion 300 when the illumination unit is not emitting light.

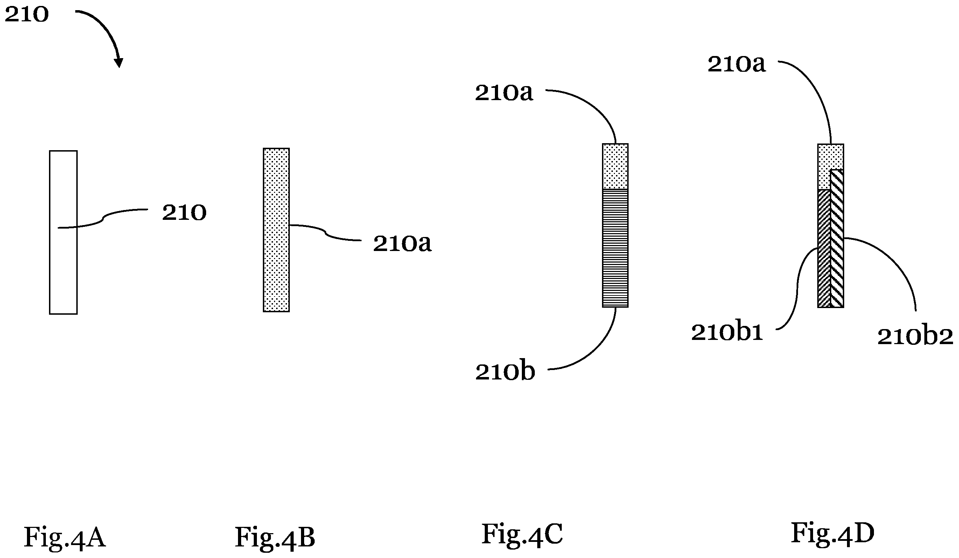

Fig. **2C** shows an aerosol generation device that may an aerosol generation device as described in the context of Figs. 2A and 2B. In the state shown in Fig. 2c, the illumination unit and its illumination region 210 is emitting light. Light emitted by the illumination region 210 is transmitted through the light-transmissive portion 300 and visible to an exterior of the device, in particular the human eye of a user of the aerosol generation device, such that the illumination region 210 provides visual feedback indicative of states of the aerosol generation device or a consumable in use with the aerosol generation device. While the illumination unit and illumination region 210 are shown to emit light at a single brightness level for the entire illumination region, two different brightness levels and regions of the illumination region 210 with different brightness levels are also possible. Such embodiments of the illumination are described in a non-limiting manner in the context of Figs. 4A to 5D.

It should be noted that in any of the embodiments of the invention described herein, the term "non-visible" denotes that the illumination unit cannot be seen through the light-transmissive portion by a naked human eye, under commonly occurring ambient lighting conditions, without any special viewing aids or equipment or under special, not naturally occurring lighting conditions, when the illumination unit is not emitting light.

Fig. **3A** shows a schematic illustration of a structure of the light-transmissive portion 300. In its simplest form, the light-transmissive portion 300 may comprise a translucent layer 320. The translucent property of the layer is such, that more of the light that is incident from an exterior of the aerosol generation device onto the translucent layer 320 is reflected or scattered back towards the exterior of the device, than is transmitted through the translucent layer 320, reflected by the illumination unit 210 back towards the translucent layer 320 and subsequently transmitted through the translucent layer 320 back to the exterior of the aerosol generation device.

As shown in Fig. **3B****,** the light-transmissive portion comprises a laminar structure that comprises a translucent layer 320 or a partially or fully transparent layer 340 that is arranged closer to the illumination unit 210, and a partially light-reflective layer 330 that is arranged on a surface of the translucent layer 320 or the partially or fully transparent layer 340 further away from the illumination unit 210 than the translucent layer 320 or the partially or fully transparent layer 340. The translucent layer 320 and the partially or fully transparent layer 340 comprise translucent or partially or fully transparent plastic materials such as PMMA, PVC, PC, PET, PTFE, a resin-based material, or a similar material.

The partially light-reflective layer may be achieved by means of a physical vapor deposition (PVD), chemical vapor deposition (CVD) and/or non-conducting vacuum metallization (NCVM) process or similar deposition method. The deposited material may comprise a copper, silver, bronze or similar metallic material. The partially light-reflective layer 330 may be an exterior layer that forms the exterior surface of the light-transmissive portion and, additionally, may provide the light-transmissive portion with a glossy or mirrored surface finish.

As shown in Fig. **3C****,** the laminar structure of the light-transmissive portion may comprise a transparent layer 340 arranged closest to the illumination unit 210. A partially light-reflective layer 330 as described above in the context of Fig. 3B is arranged on the transparent layer 340 further away from the illumination unit 210. A light-diffusive layer 350 is arranged on a surface of the light-reflective layer 330 furthest away from the illumination unit 210 and forms the exterior surface of the light-transmissive portion 300. The light-diffusive layer 350 may form the exterior surface of the light-transmissive portion 300. The light-diffusive layer 350 may form a layer that protects the light-reflective layer from external influences and may comprise a resin-based material or a transparent plastic material. Furthermore, the light-diffusive layer 350 may be colored or tinted to provide the light-transmissive portion 300 with a desired visual effect, and additionally, may provide the external surface of the light-transmissive portion with matte surface finish.

It should be noted that the layers of the laminar structure, as described above in the context of Figs. 3A to 3C, may be arranged in a different layered order. For example, in the embodiments described in the context of Fig. 3B, the light-reflective layer 330 may be arranged closest to the illumination unit 210, or in the embodiments described in the context of Fig. 3C, the light-reflective layer 330 may be arranged furthest away from the illumination unit 210 and form the exterior surface of the light-transmissive portion 300. Additionally, the light-reflective layer 330 may provide the light-transmissive portion 300 with a glossy or mirrored surface finish.

The light-reflective layer 330 reflects some light and is penetrated by the rest. Light can pass through the light-reflective layer 330 in both directions. However, when the illumination unit 210 does not emit light and the illumination region is kept dark behind the light-transmissive portion 300, relative to a surrounding area of the aerosol generation device, which is typically a bright side in this case, the dark side become difficult to see from the bright side because the dark side is masked by the much brighter reflection of the bright side.

More specifically, the light from the bright side reflected by the light-reflective layer 330 back into the same side is much greater than the light transmitted from the dark side, overwhelming the small amount of light transmitted from the dark to the bright side. This is how the illumination unit 210 is kept invisible when it doesn't emit light. On the other hand, when the illumination unit 210 emits light, the illumination region becomes a bright side and the light transmitted from the illumination unit 210 is bright enough to be visible through the light-transmissive portion 300, without being overwhelmed by the light from the surrounding area reflected by the light reflective layer 330. In this way, the light-transmissive portion 300 operates like an one-way mirror and makes the illumination unit 210 either visible or invisible from the surrounding area depending on whether the illumination unit 210 is lit or not.

It should be noted that in case the housing of an aerosol generation device according to embodiments of the invention comprises a main body and a movable panel member that comprises or substantially consists of the light-transmissive portion, the panel member and the main body are coupled close to each other to substantially prevent any light emitted from the illumination unit arranged on the main body from leaking out from between the panel member and the main body unit to prevent any leakage light from negatively impacting visibility of the illumination region through the light-transmissive portion.

It should further be noted that for any embodiment of the present invention, the illumination unit may preferably be a light source, i.e. a component that is configured to generate light. The light source may in general comprise or substantially consists of an incandescent light source, and may preferably comprise or substantially consists of a luminescent light source. Luminescent light sources such as LED light sources are particularly preferable due to their high efficiency, low heat generation, low power consumption, and compact size. The luminescent light source may be provided in a wide range of sizes, shapes and/or colors. It should further be noted that, for any embodiment of the present invention, the illumination unit emitting light through the light-transmissive portion means that the illumination unit is arranged relative to the light-transmissive portion such that the illumination unit emits light directly through the light-transmissive portion, i.e. light emitted from the illumination unit reaches the light-transmissive portion substantially without relying on any scattering or reflecting components such as a light guide or a mirror component. Furthermore, the illumination unit is arranged and configured to emit light such that light emitted through the light-transmissive portion is transmitted through all layers of the light-transmissive portion.

Fig. 4A depicts an illumination unit 210 comprising a plurality of light sources. Each of the light sources may be an LED light source that may additionally emit light in different colors. The illumination unit 210 as shown in Fig. 4A is not emitting light and therefore in an "off" state. While the illumination unit is shown to be of a rectangular size, the plurality of light source may be arranged such that they form any appropriately sized contiguous and appropriate shape.

**In** **Fig. 4B****,** all of the plurality of light sources of the illumination unit are emitting light to form a contiguous illumination region 210 that substantially matches the size and shape of the illumination unit. Alternatively, only a portion of the plurality of light source may emit light to form an illumination region 210 wherein the full extent of the illumination region 210 is different from the full extent of the illumination unit. The illumination region 210 may be illuminated at a first brightness level when the plurality of light source operating at a first power level form a region 210a illuminated at the first brightness level. In this state, the illumination unit is in an "on" state and provides visual feedback that states of the aerosol generation device are being indicated by the illumination unit. When all of the plurality of light sources of the illumination unit are emitting light at a second brightness level by operating at a second power level to form a region illuminated at the second brightness level, the difference in brightness levels enables the illumination unit to indicate a state of the aerosol generation device or of the consumable in use with the aerosol generation device. For example, when illuminated at the first brightness level, the illumination unit indicates that the aerosol generation device is turned on and not ready for use by a user, and when illuminated at the second brightness level, the illumination indicates that the aerosol generation device is turned on and ready for use by a user.

In **Fig. 4C****,** the full extent of the illumination region 210 is the combined extent of a region 210a illuminated at the first brightness level and the region 210b illuminated at the second brightness level. This configuration enables the illumination unit to indicate states of the aerosol generation device or a consumable in use with the aerosol generation device within a reference range of values or relative to a reference value, wherein the full extent of the illumination region may correspond to a maximum range of possible values or a maximum reference value for the indicated state. The indicated state may be based on the relation between the extent of the region 210b illuminated at the second brightness level and the full extent of the illumination region. For example, the full extent of the illumination region may correspond to a range of 0% to 100% of, for example, the charging level of a battery provided as a power source in the aerosol generation device, or the full extent of the illumination region may correspond to a range between a maximum amount of an aerosol generation substrate in the consumable and the level of full depletion of the aerosol generation substrate. The relative extent of the region 210b illuminated at the second brightness level compared to the full extent of the illumination region may consequently corresponds to a relative range of values or a value within the maximum range of values. For example, if the extent of the region 210b is only 60% of the full extent of the illumination region 210, the indicated state may therefore be a battery at a charging level of 60% compared to a full charging level of the battery.

As shown in Fig. **4D****,** the region 210b may comprise two regions 210b1 and 210b2 as patterns that may be the same or different from each other. The extent of the pattern 210b1 and the extent of the pattern 210b2 may be different from each other and may be independent from each other. In this configuration, the patterns 210b1 and 210b2 may each indicate different states of the aerosol generation device or consumable in use with the aerosol generation device. For example, the pattern 210b1 may indicate, in a manner as described in the context of Fig. 4C, the charging level of the battery of the aerosol generation device, and the pattern 210b2 may indicate the aerosol generation substrate depletion level of the consumable in use with the aerosol generation device.

The states that may be indicated by visual feedback comprise elapsed and/or remaining start-up time period of the device, total amount of puffs by user, total amount of puffs by user in relation to a predetermined maximum amount of puffs for a consumable, total time of use of a consumable in relation to a predetermined maximum of time of use for a consumable, time of use of the device since start-up, consumed and/or remaining amount of aerosol generation substrate in the consumable, an operational temperature of the device, and depletion level of a battery of the device, charging status of the battery etc.

Additionally, a pattern 210a/210b of the illumination region 210 may be a dynamically changing or moving pattern. Furthermore, the moving direction of the pattern may indicate a change in a state indicated by the pattern. For example, in the embodiments described in the context of Fig. 4C, the illumination unit may comprise a pattern that indicates a battery depletion level. The pattern may repeatedly move in an upwards direction, then reset to its original position, and then move upwards again, to not only indicate charging/depletion level of the battery, but that the battery is being charged, i.e. that the charging level of the battery is increasing.

Additionally, or alternatively, any pattern on the illumination region 210 may dynamically change by, for example, periodically blinking, to indicate a state of the aerosol generation device. Additionally, or alternatively, only one of the plurality of light source may emit light, and an adjacent light source of the plurality of light sources following in a direction of the illumination unit may start emitting light when previous light source stops emitting light after a predetermined amount of time to form a pattern of a moving light source to indicate a state of the aerosol generation device. Such states may comprise, for example, a low charging level of the battery, a low remaining amount of an aerosol generation substrate in the consumable in use with the aerosol generation device, or a malfunction of the aerosol generation device.

Figs. **5A, 5B, 5C** and **5D** show aerosol generation devices 100 that may be aerosol generation device as described in the context of any one of the Figs. 1A to 3C. For example, the exterior wall 200 may substantially consist of a light-transmissive portion 300 or may comprise a light-transmissive portion 300 that is only partially the size of the exterior wall. The aerosol generation device comprises an illumination unit 210 that may be an illumination unit 210 as described in the context of any one of the Figs. 1A to 4C. Each of the illumination units 210 shown in Figs. 5A to 5D comprises a plurality of light sources that are arranged to form a contiguous illumination region 210 when emitting light, wherein the illumination region 210 may be of different sizes and of different shapes, such as a triangular shape, a bent and/or curved shape, or a circular/elliptic shape. In particular, as shown in Fig. 5D, the illumination region 210 may comprise a pattern that is shaped such that the visual appearance of the shape is indicative of the type of state indicated by the pattern. For example, the pattern may have a shape reminiscent of the shape of a battery to indicate that visual feedback provided by the illumination region 210 indicates a state of the battery of the aerosol generation device such as the charging/depletion level of the battery.

While this disclosure has described certain embodiments and generally associated methods, alterations and permutations of these embodiments and methods will be apparent to those skilled in the art. Accordingly, the above description of example embodiments does not define or constrain this disclosure. Other changes, substitutions, and alterations are also possible without departing from the scope of this disclosure, as defined by the independent and dependent claims.

### LIST OF REFERENCE SIGNS USED

- 100:: Aerosol generation device
- 110:: consumable/aerosol generating substrate
- 120:: aerosol generation chamber
- 130:: power supply
- 140:: circuitry
- 200:: exterior wall
- 210:: illumination unit/region
- 210a:: illumination unit/region at first brightness
- 210b:: illumination unit/region at second brightness
- 300:: light-transmissive portion
- 320:: translucent layer
- 330:: light-reflective layer
- 340:: transparent layer
- 350:: light-diffusive layer

## Claims

1. An aerosol generation device (100) having
a housing, and
an illumination unit (210) capable of emitting light and covered by an exterior wall (200) of the housing,
the exterior wall (200) comprising or substantially consisting of a light-transmissive portion (300) arranged such that light emitted by the illumination unit (210) is transmitted through the light-transmissive portion (300),
wherein the light-transmissive portion (300) allows the illumination unit (210) to be visible through the light-transmissive portion (300) from the exterior of the device (100) when the illumination unit (210) emits light, and
**characterized in that**
the light-transmissive portion (300) comprises a laminar structure including a partially (320) or fully transparent (340) layer and a partially light-reflective layer (330), and the light-transmissive portion (300) prevents the illumination unit (210) from being visible through the light-transmissive portion (300) from the exterior of the device (100) when the illumination unit (210) does not emit light.

2. The aerosol generation device (100) according to the preceding claim wherein the partially (320) or fully transparent (340) layer is arranged closer the illumination unit (210) than the partially light-reflective layer (330).

3. The aerosol generation device (100) according to the preceding claim, wherein the partially light-reflective layer (330) comprises a coating created by a physical vapor deposition (PVD), chemical vapor deposition (CVD) and/or non-conducting vacuum metallization (NCVM) process.

4. The aerosol generation device (100) according to any one of claims 1 to 3, wherein the partially light-reflective layer (330) comprises an aluminum, copper, or bronze material.

5. The aerosol generation device (100) according to any one of the preceding claims, wherein the laminar structure comprises a light-diffusive layer (350).

6. The aerosol generation device (100) according to the preceding claim, wherein the light-diffusive layer (350) forms the exterior surface of the light-transmissive portion (300).

7. The aerosol generation device (100) according to any one of claims 1 to 6, wherein one or more layers of the laminar structure are colored or tinted.

8. The aerosol generation device (100) according to any one of the preceding claims, wherein the housing comprises a main body on which the illumination unit (210) is arranged, and a panel member that is movably and/or detachably attached to the main body and that comprises or substantially consists of the exterior wall (200) of the housing.

9. The aerosol generation device (100) according to any one of the preceding claims, wherein the shape and/or length and/or width and/or radius of the light-transmissive portion (300) corresponds to the shape and/or length and/or width and/or radius, respectively, of the illumination unit (210).

10. The aerosol generation device 100 according to any one of the preceding claims, wherein the illumination unit (210) is positioned such that at least parts of the light emitted by the illumination unit (210) passes through the light-transmissive portion (300) in a direction substantially perpendicular to the exterior surface of the exterior wall (200) of the housing.

11. The aerosol generation device (100) according to any one of the preceding claims, wherein the light-transmissive portion (300) and at least parts of the housing adjacent to the light-transmissive portion (300) and/or substantially the entire exterior wall (200) of the housing are provided with substantially the same exterior surface finish.

12. The aerosol generation device (100) according to the preceding claim, wherein the surface finish is a glossy, mirrored, or matte finish.

13. The aerosol generation device (100) according to the preceding claim, wherein the surface finish is provided by one of the partially light-reflective layer (330), the light-diffusive layer (350), and a combination thereof.

14. The aerosol generation device (100) according to any one of the preceding claims, wherein the illumination unit (210) comprises one or more LED light sources or LED light strips.

15. The aerosol generation device (100) according to any one of the preceding claims, wherein the illumination unit (210) comprises a plurality of light sources arranged in a straight or curved line.

## Patentansprüche

1. Aerosolerzeugungsgerät (100) mit
einem Gehäuse, und
einer Beleuchtungseinheit (210), die Licht emittieren kann und durch eine Außenwand (200) des Gehäuses abgedeckt ist,
wobei die Außenwand (200) einen lichtdurchlässigen Abschnitt (300) umfasst oder im Wesentlichen daraus besteht, der so angeordnet ist, dass von der Beleuchtungseinheit (210) emittiertes Licht durch den lichtdurchlässigen Abschnitt (300) übertragen wird,
wobei der lichtdurchlässige Abschnitt (300) ermöglicht, dass die Beleuchtungseinheit (210) durch den lichtdurchlässigen Abschnitt (300) von außerhalb des Geräts (100) sichtbar ist, wenn die Beleuchtungseinheit (210) Licht emittiert, und
**dadurch gekennzeichnet, dass**
der lichtdurchlässige Abschnitt (300) eine laminare Struktur umfasst, die eine teilweise (320) oder vollständig transparente (340) Schicht und eine teilweise lichtreflektierende Schicht (330) beinhaltet, und der lichtdurchlässige Abschnitt (300) verhindert, dass die Beleuchtungseinheit (210) durch den lichtdurchlässigen Abschnitt (300) von außerhalb des Geräts (100) sichtbar ist, wenn die Beleuchtungseinheit (210) kein Licht emittiert.

2. Aerosolerzeugungsgerät (100) nach dem vorhergehenden Anspruch, wobei die teilweise (320) oder vollständig transparente (340) Schicht näher an der Beleuchtungseinheit (210) angeordnet ist als die teilweise lichtreflektierende Schicht (330).

3. Aerosolerzeugungsgerät (100) nach dem vorhergehenden Anspruch, wobei die teilweise lichtreflektierende Schicht (330) eine Beschichtung umfasst, die durch einen physikalischen Gasphasenabscheidungs- (PVD), chemischen Gasphasenabscheidungs- (CVD) und/oder nichtleitenden Vakuummetallisierungs- (NCVM) Prozess erzeugt wird.

4. Aerosolerzeugungsgerät (100) nach einem der Ansprüche 1 bis 3, wobei die teilweise lichtreflektierende Schicht (330) ein Aluminium-, Kupfer- oder Bronzematerial umfasst.

5. Aerosolerzeugungsgerät (100) nach einem der vorhergehenden Ansprüche, wobei die laminare Struktur eine lichtstreuende Schicht (350) umfasst.

6. Aerosolerzeugungsgerät (100) nach dem vorhergehenden Anspruch, wobei die lichtstreuende Schicht (350) die Außenfläche des lichtdurchlässigen Abschnitts (300) bildet.

7. Aerosolerzeugungsgerät (100) nach einem der Ansprüche 1 bis 6, wobei eine oder mehrere Schichten der laminaren Struktur gefärbt oder getönt sind.

8. Aerosolerzeugungsgerät (100) nach einem der vorhergehenden Ansprüche, wobei das Gehäuse einen Hauptkörper, auf dem die Beleuchtungseinheit (210) angeordnet ist, und ein Plattenelement umfasst, das beweglich und/oder abnehmbar an dem Hauptkörper angebracht ist und das die Außenwand (200) des Gehäuses umfasst oder im Wesentlichen daraus besteht.

9. Aerosolerzeugungsgerät (100) nach einem der vorhergehenden Ansprüche, wobei die Form und/oder Länge und/oder Breite und/oder Radius des lichtdurchlässigen Abschnitts (300) der Form und/oder Länge und/oder Breite und/oder Radius der Beleuchtungseinheit (210) entspricht.

10. Aerosolerzeugungsgerät (100) nach einem der vorhergehenden Ansprüche, wobei die Beleuchtungseinheit (210) so positioniert ist, dass zumindest Teile des von der Beleuchtungseinheit (210) emittierten Lichts durch den lichtdurchlässigen Abschnitt (300) in einer Richtung im Wesentlichen senkrecht zu der Außenfläche der Außenwand (200) des Gehäuses verlaufen.

11. Aerosolerzeugungsgerät (100) nach einem der vorhergehenden Ansprüche, wobei der lichtdurchlässige Abschnitt (300) und zumindest Teile des Gehäuses neben dem lichtdurchlässigen Abschnitt (300) und/oder im Wesentlichen die gesamte Außenwand (200) des Gehäuses mit im Wesentlichen der gleichen äußeren Oberflächenbeschaffenheit versehen sind.

12. Aerosolerzeugungsgerät (100) nach dem vorhergehenden Anspruch, wobei die Oberflächenbeschaffenheit eine glänzende, verspiegelte oder matte Beschaffenheit ist.

13. Aerosolerzeugungsgerät (100) nach dem vorhergehenden Anspruch, wobei die Oberflächenbeschaffenheit durch eine der teilweise lichtreflektierenden Schicht (330), der lichtstreuenden Schicht (350) und einer Kombination davon bereitgestellt wird.

14. Aerosolerzeugungsgerät (100) nach einem der vorhergehenden Ansprüche, wobei die Beleuchtungseinheit (210) eine oder mehrere LED-Lichtquellen oder LED-Lichtstreifen umfasst.

15. Aerosolerzeugungsgerät (100) nach einem der vorhergehenden Ansprüche, wobei die Beleuchtungseinheit (210) eine Vielzahl von Lichtquellen umfasst, die in einer geraden oder gekrümmten Linie angeordnet sind.

## Revendications

1. Un dispositif de génération d'aérosol (100), avec :
un boîtier, et
une unité d'illumination (210) capable d'émettre de la lumière et recouverte par une paroi extérieure (200) du boîtier,
la paroi extérieure (200) comprenant, ou étant substantiellement constituée de, une partie laissant passer la lumière (300) agencée de telle manière que la lumière émise par l'unité d'illumination (210) puisse passer au travers de la partie laissant passer la lumière (300),
dans lequel la partie laissant passer la lumière (300) permet à l'unité d'illumination (210) d'être visible au travers de la partie laissant passer la lumière (300) depuis l'extérieur du dispositif (100) lorsque l'unité d'illumination (210) émet de la lumière, et
**caractérisé en ce que**
la partie laissant passer la lumière (300) comprend une structure laminaire comprenant une couche partiellement (320) ou totalement (340) transparente et une couche réfléchissant partiellement la lumière (330), et la partie laissant passer la lumière (300) empêche que l'unité d'illumination (210) ne soit visible au travers de la partie laissant passer la lumière (300) depuis l'extérieur du dispositif (100) lorsque l'unité d'illumination (210) n'émet pas de lumière.

2. Le dispositif de génération d'aérosol (100) selon la revendication précédente dans lequel la couche partiellement (320) ou totalement (340) transparente est agencée plus proche de l'unité d'illumination (210) que la couche réfléchissant partiellement la lumière (330).

3. Le dispositif de génération d'aérosol (100) selon la revendication précédente, dans lequel la couche réfléchissant partiellement la lumière (330) comprend un revêtement créé par un processus de dépôt physique en phase vapeur (PVD), de dépôt chimique en phase vapeur (CVD) et/ou de métallisation sous vide non conducteur (NCVM).

4. Le dispositif de génération d'aérosol (100) selon l'une des revendications 1 à 3, dans lequel la couche réfléchissant partiellement la lumière (330) comprend un matériau en aluminium, en cuivre, ou en bronze.

5. Le dispositif de génération d'aérosol (100) selon l'une des revendications précédentes, dans lequel la structure laminaire comprend une couche diffusant la lumière (350).

6. Le dispositif de génération d'aérosol (100) selon la revendication précédente, dans lequel la couche diffusant la lumière (350) forme la structure extérieure de la partie laissant passer la lumière (300).

7. Le dispositif de génération d'aérosol (100) selon l'une des revendications 1 à 6, dans lequel une ou plusieurs couches de la structure laminaire sont colorées ou teintées.

8. Le dispositif de génération d'aérosol (100) selon l'une des revendications précédentes, dans lequel le boîtier comprend un corps principal sur lequel est agencée l'unité d'illumination (210), et un élément de panneau qui est mobile et/ou fixé de façon détachable au corps principal et qui comprend, ou est substantiellement constitué de, la paroi extérieure (200) du boîtier.

9. Le dispositif de génération d'aérosol (100) selon l'une des revendications précédentes, dans lequel la forme et/ou la longueur et/ou la largeur et/ou le rayon de la partie laissant passer la lumière (300) correspondent, respectivement, à la forme et/ou à la longueur et/ou à la largeur et/ou au rayon de l'unité d'illumination (210).

10. Le dispositif de génération d'aérosol (100) selon l'une des revendications précédentes, dans lequel l'unité d'illumination (210) est positionnée de telle manière qu'au moins des parties de la lumière émise par l'unité d'illumination (210) traversent la partie laissant passer la lumière (300) dans une direction substantiellement perpendiculaire à la surface extérieure de la paroi extérieure (200) du boîtier.

11. Le dispositif de génération d'aérosol (100) selon l'une des revendications précédentes, dans lequel la partie laissant passer la lumière (300) et au moins des parties du boîtier adjacentes à la partie laissant passer la lumière (300) et/ou substantiellement la totalité de la paroi extérieure (200) du boîtier sont obtenues avec substantiellement la même finition extérieure de surface.

12. Le dispositif de génération d'aérosol (100) selon la revendication précédente, dans lequel la finition de surface est une finition brillante, spéculaire, ou mate.

13. Le dispositif de génération d'aérosol (100) selon la revendication précédente, dans lequel la finition de surface est obtenue par l'une d'entre la couche réfléchissant partiellement la lumière (330), la couche diffusant la lumière (350), et une combinaison des précédentes.

14. Le dispositif de génération d'aérosol (100) selon l'une des revendications précédentes, dans lequel l'unité d'illumination (210) comprend une ou plusieurs sources lumineuses LED ou des rubans lumineux LED.

15. Le dispositif de génération d'aérosol (100) selon l'une des revendications précédentes, dans lequel l'unité d'illumination comprend une pluralité de sources lumineuses agencées suivant une ligne droite ou courbe.
